# FASCICULE DE BREVET EUROPEEN

(11) **EP 0 232 298 B1**
(45) Date de publication et mention de la délivrance du brevet: **05.01.1994**
(21) Numéro de dépôt: 86904209.3
(22) Date de dépôt: 04.07.1986
(51) Int. Cl.: H01L 29/747

(54) **TRIAC DESENSIBILISE VIS-A-VIS DES RISQUES DE REAMORCAGE A LA COMMUTATION SUR CHARGE REACTIVE**
GEGENÜBER EINER WIEDERZÜNDUNG BEI SCHALTVORGÄNGEN MIT EINER REAKTIVEN LAST UNEMPFINDLICHER TRIAC
TRIAC DESENSITIZED IN REGARD TO RISKS OF RESTRIKING UPON SWITCHING UNDER REACTIVE LOAD

(30) Priorité: 30.07.1985 FR 8511642
(43) Date de publication de la demande: 19.08.1987
(73) Titulaire: SGS-THOMSON MICROELECTRONICS S.A., 94250 Gentilly (FR)
(72) Inventeur: BACUVIER, Pierre, F-37000 Luynes (FR)
(74) Mandataire: de Beaumont, Michel
(86) Numéro de dépôt international: FR8600238
(87) Numéro de publication internationale: WO8700971

(56) Documents cités:
- CH-A- 513 518
- CH-A- 531 793
- DE-A- 3 401 407
- FR-A- 1 578 544
- FR-A- 2 144 582
- Patent Abstracts of Japan, vol 6, no. 123 (E-117)(1001) 8 Juillet 1982 & JP-A-5749269

## Description

L'invention concerne les triacs.

Les triacs sont des composants semiconducteurs ayant deux électrodes principales et une électrode de commande (gâchette) cette dernière permettant de déclencher la mise en conduction du triac pour autoriser le passage de courant entre les électrodes principales.

Lorsque le triac a été mis en conduction par une impulsion appropriée sur sa gâchette, il reste conducteur jusqu'à un passage par zéro du courant qui circule entre ses électrodes principales, puis il se bloque et ne doit en principe être rendu conducteur que lors d'une nouvelle impulsion de gâchette.

Les passages par zéro du courant entre les électrodes principales sont imposés par le circuit extérieur au triac.

En particulier on utilise les triacs dans des circuits alimentés en énergie alternative, pour commander des charges qui peuvent être soit complètement résistives soit plus ou moins inductives ou capacitives. La commande de charges plus ou moins inductives est très fréquente puisqu'on la rencontre notamment dans la commande des moteurs.

Lorsque la charge est inductive il y a un retard de phase entre le courant qui traverse la charge et la tension d'alimentation aux bornes de cette charge. Il en résulte qu'au moment du passage à zéro du courant dans le triac, la tension aux bornes de la charge est non nulle (alors qu'elle le serait avec une charge purement résistive).

Non seulement cette tension n'est pas nulle mais elle peut être une fraction importante de la tension d'alimentation.

Or lorsque le triac se bloque sous l'effet de l'annulation du courant qui le traverse, il acquiert une impédance très élevée qui fait que la quasi-totalité de la tension d'alimentation va se retrouver brutalement aux bornes du triac et non plus aux bornes de la charge.

Il y a donc à l'instant du blocage du triac une croissance très rapide de la tension aux bornes du triac, tension qui passe en un très court instant de zéro à une fraction importante de la tension d'alimentation.

Il est connu que cette croissance très rapide peut provoquer un amorçage du triac, c'est-à-dire une remise en conduction intempestive (qui va durer jusqu'à la prochaine annulation du courant dans la charge). Cet amorçage, dit amorçage en dV/dt, est tout à fait indésirable puisqu'on souhaite que le triac ne soit remis en conduction que par des impulsions de gâchette à des instants bien contrôlés.

Ce phénomène est d'autant plus gênant que le réamorçage en dV/dt après une phase de conduction semble se produire pour une valeur de dV/dt (gradient de croissance temporelle de la tension) nettement plus faible que la valeur à laquelle le triac résisterait si on essayait de l'amorcer en dV/dt sans phase de conduction préalable. En présence d'une phase de conduction préalable, la résistance du composant à ce réamorçage indésirable est appelée "tenue en dV/dt à la commutation à l'ouverture".

Il est donc souhaitable de réaliser des triacs qui soient peu sensibles à une remise en conduction par amorçage en dV/dt à la commutation.

Cependant on souhaite que ces triacs soient sensibles à une commande par un faible courant de gâchette.

Ces deux impératifs entraînent des contraintes de conception contradictoires, et ceci d'autant plus que l'on cherche en général à obtenir des triacs qui sont suffisamment sensibles quelles que soient les polarités des tensions aux bornes des différentes électrodes du triac.

On rappelle à ce propos que le déclenchement d'un triac se fait selon quatre modes distincts qui sont les suivants, dans lesquels on prend comme référence de potentiel une électrode principale A1, et on examine le potentiel V2 de l'autre électrode principale A2 et le potentiel Vg de la gâchette G :
- déclenchement dans le premier quadrant :
   V2 positif, Vg positif,
- déclenchement dans le deuxième quadrant :
   V2 positif, Vg négatif,
- déclenchement dans le troisième quadrant :
   V2 négatif, Vg négatif,
- déclenchement dans le quatrième quadrant :
   V2 négatif, Vg positif.

L'obtention d'une sensibilité suffisante au déclenchement par la gâchette dans ces quatre quadrants se traduit par des configurations particulières des différentes zones dopées et électrodes métalliques qui constituent la structure interne du triac.

Les figures 1 à 3 représentent une configuration normale de triac à gâchette dite centrale.

Pour expliquer cette structure on a représenté d'abord en figure 1 une coupe transversale de la structure, puis en figure 2 une vue de dessus montrant le découpage des zones dopées (zones mouchetées de type N ou non mouchetées de type P, entourées de traits fins) et le découpage des électrodes A1 et G (zone hachurées et entourées de traits gras), et enfin en figure 3 une vue de dessous montrant également le découpage des zones dopées et l'électrode inférieure A2.

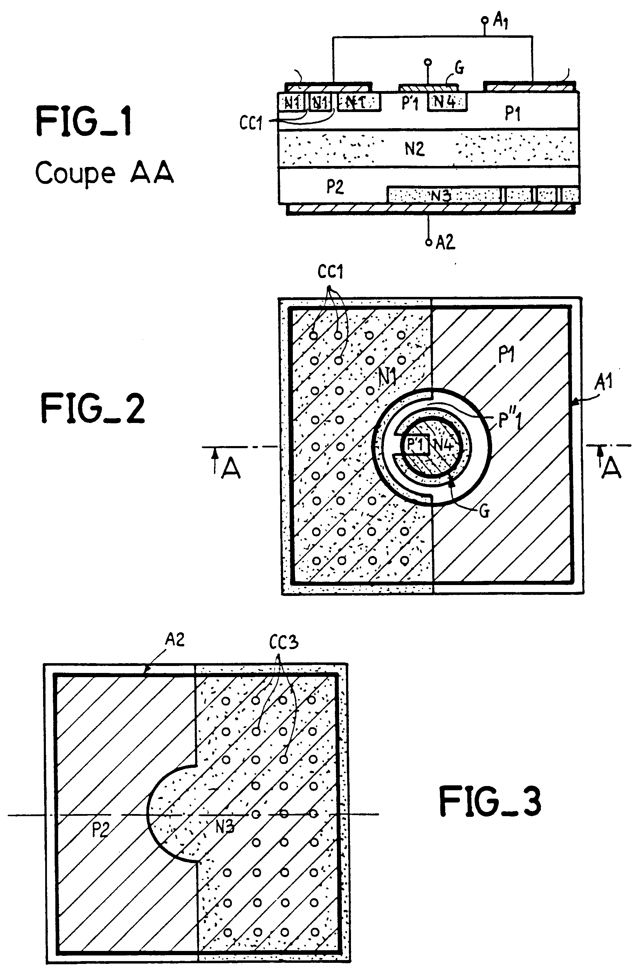

Les régions semiconductrices dopées constituant le triac sont les régions N1, N2, N3, N4 de type N et P1, P2 de type P placées en sandwich. Sur les figures les régions N sont mouchetées pour les distinguer des régions P qui ne le sont pas. En particulier, sur les figures 2 et 3 on a représenté les découpages des zones N et P affleurant à la surface de la structure.

La région N2 est une couche centrale s'étendant au milieu de toute la structure.

La région P1 recouvre toute la région N2 d'un côté (côté de la face supérieure).

La région P2 recouvre toute la région N2 de l'autre côté (côté de la face inférieure).

La région N1 est formée à la surface de la région P1 mais en gros seulement dans la moitié de la structure (moitié gauche sur les figures) ; la région N1 affleure à la surface semiconductrice (face supérieure) là où elle existe. La région P1 affleure sur cette même surface là où il n'y a pas de région N1 ; en pratique, des petits trous CC1 dits courts-circuits d'émetteur sont formés dans la région N1; ce sont des trous par lesquels la région P1 remonte à la surface dans la zone où la région N1 est généralement présente.

La région N3 est formée à la surface de la région P2, en gros dans un peu plus de la moitié de la surface de la structure. La région N3 affleure à la surface (qui constitue la face inférieure) de la structure semiconductrice là où elle est présente. La région P2 affleure sur le reste de la face inférieure. Des trous de court-circuit d'émetteur CC3 sont répartis dans la majeure partie de la région N3, trous par lesquels la région P3 remonte à la surface dans la zone qui est globalement de type N.

La région N4 est une petite région équivalente à la région N1, formée dans la région P1 et affleurant du même côté que la région N1 mais localisée ailleurs et destinée à être recouverte par la métallisation de gâchette. Pour un triac à gâchette centrale la région N4 est au centre de la structure ; pour un triac à gâchette en coin elle serait dans un coin. De plus, la région N4 est localisée, dans les triacs classiques en regard d'une portion de région N3, et plus précisément en regard d'une portion de zone N3 qui ne comporte pas de trous de court-circuits CC3.

La métallisation A2 recouvre la quasi totalité de la face arrière, c'est-à-dire la région N3 là où elle est présente et la région P2 sur le reste de la surface.

La métallisation A1 recouvre une grande partie de la face avant, le reste étant recouvert par la métallisation de gâchette G mais un intervalle étant évidemment prévu entre ces métallisations pour qu'il n'y ait pas de court-circuit entre elles.

Plus précisément, la métallisation A1 recouvre la région N1 (y compris d'ailleurs les trous de court-circuit CC1 par où la région P1 remonte à la surface) sauf une petite bande qui est la portion du région N1 la plus proche de la région N4. Elle recouvre également la région P1 sauf une petite bande qui est la portion de région P1 la plus proche de la région N4.

Enfin, la métallisation G recouvre essentiellement la région N4 sans déborder sur la région P1 sauf dans une petite zone P'1 de la région P1 ; cette petite zone P'1 recouverte par la métallisation G, est une zone qui est placée à l'écart de la majeure partie de la région P1 mais qui n'en est pas complètement séparée puisqu'elle lui est reliée par une bande étroite P''1 de région P1 qui n'est recouverte ni par la métallisation A1 ni par la métallisation G.

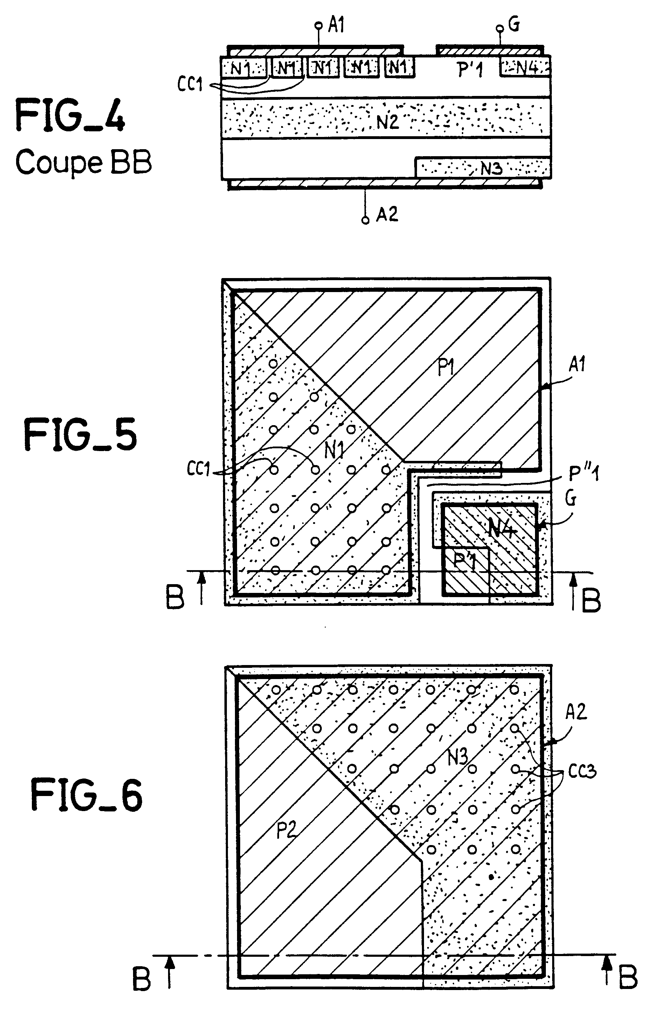

Les figures 4 à 6, analogues aux figures 1 à 3, représentent la structure d'un triac à gâchette en coin. La description faite précédemment reste valable et les références des zones N à P sont les mêmes. On fera attention que la figure 6 n'est pas véritablement une vue de dessous : c'est une vue de dessous inversée pour que les zones en regard se correspondent. En d'autres mots le coin en bas a droite de la figure 5 est la zone de gâchette qui est en regard du coin en bas à droite de la figure 5 (partie de zone N3 dépourvue de trous de court-circuit CC3). On peut aussi dire que la figure 6 représente la face inférieure de la structure vue par transparence dans la même direction que la figure 5 (vue de dessus).

Les triacs représentés sur les figures 1 à 6 présentent des caractéristiques de tenue en dV/dt insuffisantes, et cela tout spécialement lors de l'application de fronts de tension abrupts après une phase de conduction du triac.

Le document DE-A-3401407 décrit un triac correspondant sensiblement au préambule de la revendication 1 mais ne comprenant pas de moyens pour améliorer la tenue en dV/dt à la commutation à l'ouverture. Il en est de même pour le résumé Patents Abstracts of Japon, vol. 6, N° 123, (E-117) [1001], 8 juillet 1982.

Pour améliorer cette caractéristique de tenue en dV/dt à la commutation à l'ouverture, la présente invention propose un triac dont la constitution diffère de celles qui ont été décrites ci-dessus par les caractéristiques de la partie caractérisante de la revendication 1.

Plus précisément les endroits où la région P2 affleure sont situés à la fois sous la partie P'1 de la région P1 et sous une partie de la région N4 (cette partie de la région N4 étant de préférence celle qui est plus éloignée de la région P1). La partie affleurante de la région P2 peut-être adjacente à la majeure partie de la région P2 ou alors consister en remontées ponctuelles de la région P2 à travers la région N3 (trous de court-circuit).

Il en résulte une structure de triac telle que l'électrode de gâchette comporte trois zones, l'une étant à l'aplomb d'une superposition de cinq régions de types de conductivité alternés (N4, P1, N2, P2, N3), une autre à l'aplomb d'une superposition de quatre régions de types de conductivité alternés (N4, P1, N2, P2) et la troisième à l'aplomb d'une superposition de trois régions de types de conductivité alternés (P'1, N2, P2).

Une définition détaillée de l'invention est la suivante: le triac comprend une structure semiconductrice pourvue d'une face supérieure recouverte d'une première électrode principale (A1) et d'une électrode de gâchette (G), et d'une face inférieure recouverte d'une seconde électrode principale (A2), la structure comportant :
- une couche centrale de type N (N2) s'étendant au milieu de toute la structure,
- une première couche de type P (P1) recouvrant la couche centrale (N2) du côté de la face supérieure,
- une seconde couche de type P (P2) recouvrant la couche centrale (N2) du côté de la face inférieure,
- une première région de type N (N1) formée sensiblement dans une moitié de la structure dans la première couche de type P (P1) et affleurant sur la face supérieure de cette moitié, la première région de type N (N1) étant par ailleurs percée de petits trous dits courts-circuits d'èmetteur (CC1) par où la première couche de type P (P1) remonte et affleure sur la face supérieure,
- une deuxième région de type N (N4) formée dans une autre partie de la Première couche de type P (P1) et affleurant sur la face supérieure dans cette autre partie alors que la première couche de type P (P1) affleure sur le reste de la face supérieure,
- une troisième région de type N (N3) formée sensiblement dans l'autre moitié de la structure dans la seconde couche de type P (P2) et affleurant sur la face inférieure de cette moitié alors que la seconde couche de type P (P2) affleure sur le reste de la face inférieure, la troisième région de type N (N3) étant au moins partiellement en face de la deuxième région de type N (N4) et étant par ailleurs percée de petits trous dits court-circuits d'émetteur (CC3) par lesquels la seconde couche de type P (P2) affleure sur la face inférieure,
- la première électrode principale (A1) recouvrant la quasi totalité de la première région de type N (N1) y compris les trous de court-circuit de cette première région, et recouvrant une majeure partie affleurante de la première couche de type P (P1), mais ne recouvrant pas la première région de type N (N1) et la première couche de type P (P1) au voisinage immédiat de la deuxième région de type N (N4);
- l'électrode de gâchette (G) recouvrant la quasi totalité de la deuxième région de type N (N4) ainsi qu'une petite partie (P'1) affleurante de la première couche de type P (P1), cette petite partie étant espacée de la majeure partie affleurante de la première couche de type P (P1) et étant reliée à cette majeure partie par une portion (P''1) étroite affleurante de la première couche de type P (P1), cette portion étroite entourant la deuxième région de type N (N4) et n'étant pas recouverte par une électrode ;
- l'électrode de gâchette étant partiellement en face d'une partie affleurante de la seconde couche de type P (P2) et partiellement en face d'une partie de la troisième région de type N (N3),
- une partie de la deuxième région de type N (N4) étant en face d'une part de ladite partie affleurante de la seconde couche de type P (P2) ;
- dans cette structure, on prévoit qu'une part de ladite partie affleurante de la seconde couche de type P (P2) est située au-dessous de la petite partie (P'1) affleurante de la première couche de type P (P1) qui est recouverte par l'électrode de gâchette (G).

En particulier on prévoira que cette partie affleurante de la deuxième couche de type P s'étend au-dessous de la petite partie (P'1) affleurante de la première couche de type P, partie dont on rappelle qu'elle est recouverte par l'électrode de gâchette.

On prévoira aussi de préférence qu'une partie de troisième région de type N qui est à l'aplomb de l'électrode de gâchette n'est pas percée de trous de court-circuit alors que des trous de court-circuit sont répartis dans le reste de la troisième région.

D'autres modes de réalisation de l'invention sout indiqués dans les revendications dépendantes.

Les figures 1 à 6 ayant déjà été décrites il n'y a pas à revenir dessus.

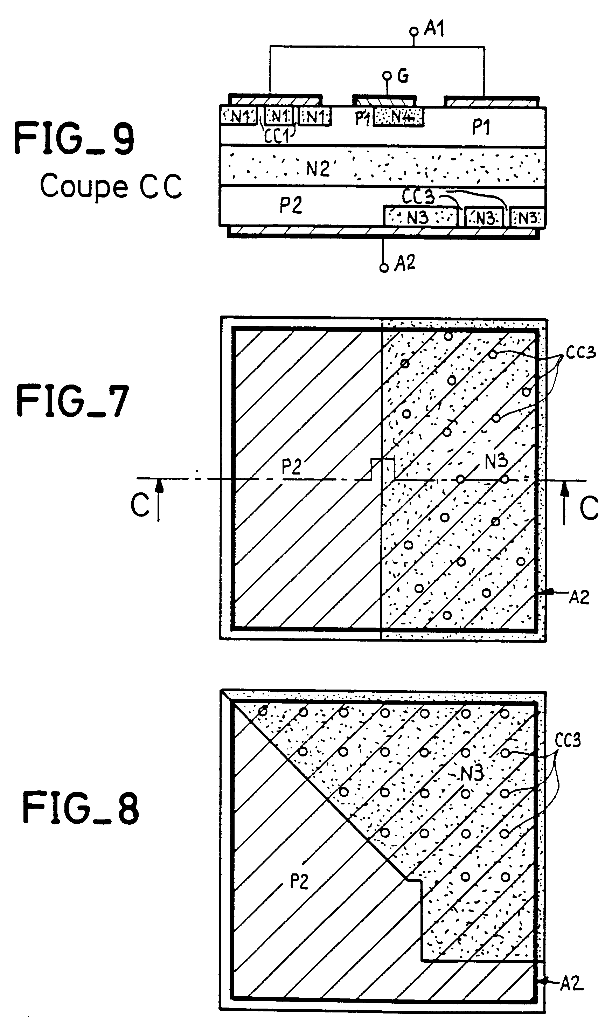

La figure 7 représente une vue de la face inférieure d'un triac selon l'invention (gâchette centrale).

La figure 8 représente une vue de la face inférieure d'un triac selon l'invention (à gâchette en coin).

La figure 9 représente une coupe d'un triac selon l'invention.

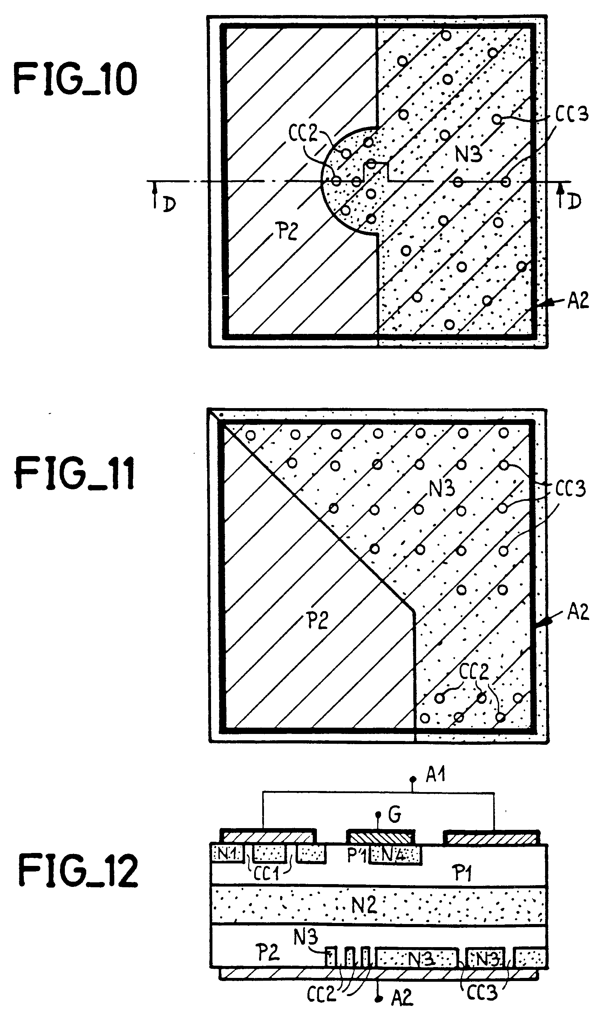

La figure 10 représente une vue de la face inférieure d'un autre mode de réalisation (gâchette centrale).

La figure 11 représente une vue de la face inférieure d'un autre mode de réalisation (gâchette en coin).

La figure 12 représente une coupe d'un triac selon l'autre mode de réalisation (gâchette centrale).

Les figures 7 et 8 sont équivalentes aux figures 3 et 6 respectivement (vues de dessous avec inversion ou vues de dessus par transparence). La figure 7 correspond au triac dont la vue de dessus est celle de la figure 2. La figure 8 correspond au triac dont la vue de dessus est celle de la figure 5. Les échelles des dessins sont les mêmes.

Elles montrent clairement les délimitations des zones P2 et N3 qui constituent l'invention.

Sur la figure 7 on voit que les surfaces des régions P2 et N3 affleurantes sont pratiquement identiques, la délimitation de ces zones se faisant par une ligne qui passe à l'aplomb du centre de l'électrode de gâchette.

En superposant les figures 2 et 7, on voit clairement que l'électrode de gâchette G comporte une moitié ou sensiblement une moitié à l'aplomb de la région P2 et une moitié à l'aplomb de la région N3 et plus précisément à l'aplomb d'une portion de région N3 dépourvue de court-circuits d'émetteur.

La région P'1 en contact avec l'électrode de gâchette est à l'aplomb de la région P2.

En pratique, on voit qu'également une partie de la région N4 (celle qui est la plus proche de la région N1) et une partie P''1 de la région P1 (portion affleurante étroite entourant la région N4, non recouverte par une électrode, et reliant la partie P'1 à la majeure partie affleurante de la région P1) sont également à l'aplomb de la région P2.

Les mêmes remarques s'appliquent au cas du triac à gâchette en coin, ce que l'on peut observer en superposant les figures 5 et 8.

Toutefois, dans la configuration dessinée, la portion affleurante étroite P''1 de type P (reliant la petite zone P'1 à la majeure partie affleurante de la couche P1) est en partie à l'aplomb de la région N3, de même d'ailleurs qu'une bande de région N4 qui est immédiatement adjacente à cette portion étroite.

La figure 9 montre pour compléter la représentation une coupe de triac selon l'invention (ici le triac à gâchette centrale de la figure 2 ; la figure 9 est donc à comparer à la figure 1), cette coupe étant faite à travers la gâchette selon une ligne brisée CC visible sur la figure 7. Cette ligne brisée CC est choisie de manière à montrer les différentes superpositions de régions que l'on trouve à l'aplomb de la gâchette.

On constate que l'électrode de gâchette G comprend une partie à l'aplomb d'une superposition de cinq couches de types de conductivité alternés (N4, P1, N2, P2, N3), une autre partie à l'aplomb d'une superposition de quatre couches de types de conductivité alternés (N4, P1, N2, P2), et enfin une partie à l'aplomb d'une superposition de trois couches (P'1 N2, P2). En ce qui concerne la partie à l'aplomb des cinq couches, il faut préciser que la couche inférieure (N3) est une couche continue, c'est-à-dire non pourvue de trous de court-circuit.

L'expérience montre que les triacs ainsi constitués se comportent particulièrement bien en ce qui concerne la résistance à l'amorçage en dV/dt à la commutation et cela sans affecter de manière significative la sensibilité au déclenchement par un courant de gâchette dans les quadrants I, II, III.

Il est souhaitable de prévoir pour ce type de triac des circuits de commande imposant le déclenchement exclusivement dans les quadrants I, II, et III, ce qui ne pose d'ailleurs pas de problème particulier puisque le déclenchement à l'aide de la tension du réseau alternatif peut se faire dans les quadrants I et III tandis qu'un déclenchement par un circuit intégré de commande peut se faire dans les quadrants II et III.

Les figures 10, 11 et 12 analogues respectivement aux figures 7, 8 et 9 et affectées des mêmes références représentent un mode de réalisation différent dans lequel la région P2 affleure à la surface à l'aplomb de l'électrode de gâchette G non pas sous forme d'une extension de la majeure partie affleurante de la région P2 mais sous forme de trous de court-circuits CC2 par lesquels la région P2 remonte à la surface à travers la région N3.

Ces trous CC2 sont régulièrement répartis à l'endroit ou se situaient l'extension de la région P2 aux figures 7 à 9 ; plus précisément l'électrode de gâchette G comporte une première moitié ou sensiblement une moitié qui est à l'aplomb d'une portion de région N3 percée de trous de court-circuit CC2, et une deuxième moitié à l'aplomb d'une autre portion de région N3 non percée de trous de court-circuit. La première moitié est celle qui recouvre la région P'1 et la portion de région N4 la plus éloignée de la région P1. La deuxième moitié est la plus proche de la région P1.

Comme les figures 7 et 8, les figures 10 et 11 sont respectivement à superposer aux figures 2 et 5. La figure 12 est une coupe de la figure 10 à travers la ligne D-D.

## Revendications

1. Triac comprenant une structure semiconductrice pourvue d'une face supérieure recouverte d'une première électrode principale (A1) et d'une électrode de gâchette (G), et d'une face inférieure recouverte d'une seconde électrode principale (A2), la structure comportant :
- une couche centrale de type N (N2) s'étendant au milieu de toute la structure,
- une première couche de type P (P1) recouvrant la couche centrale (N2) du côté de la face supérieure,
- une seconde couche de type P (P2) recouvrant la couche centrale (N2) du côté de la face inférieure,
- une première région de type N (N1) formée sensiblement dans une moitié de la structure dans la première couche de type P (P1) et affleurant sur la face supérieure de cette moitié, la première région de type N (N1) étant par ailleurs percée de petits trous dits courts-circuits d'èmetteur (CC1) par où la première couche de type P (P1) remonte et affleure sur la face supérieure,
- une deuxième région de type N (N4) formée dans une autre partie de la première couche de type P (P1) et affleurant sur la face supérieure dans cette autre partie alors que la première couche de type P (P1) affleure sur le reste de la face supérieure,
- une troisième région de type N (N3) formée sensiblement dans l'autre moitié de la structure dans la seconde couche de type P (P2) et affleurant sur la face inférieure de cette moitié alors que la seconde couche de type P (P2) affleure sur le reste de la face inférieure, la troisième région de type N (N3) étant au moins partiellement en face de la deuxième région de type N (N4) et étant par ailleurs percée de petits trous dits court-circuits d'émetteur (CC3) par lesquels la seconde couche de type P (P2) affleure sur la face inférieure,
- la première électrode principale (A1) recouvrant la quasi totalité de la première région de type N (N1) y compris les trous de court-circuit de cette première région, et recouvrant une majeure partie affleurante de la première couche de type P (P1), mais ne recouvrant pas la première région de type N (N1) et la première couche de type P (P1) au voisinage immédiat de la deuxième région de type N (N4) ;
- l'électrode de gâchette (G) recouvrant la quasi totalité de la deuxième région de type N (N4) ainsi qu'une petite partie (P'1) affleurante de la première couche de type P (P1), cette petite partie étant espacée de la majeure partie affleurante de la première couche de type P (P1) et étant reliée à cette majeure partie par une portion (P''1) étroite affleurante de la première couche de type P (P1), cette portion étroite entourant la deuxième région de type N (N4) et n'étant pas recouverte par une électrode ;
- l'électrode de gâchette étant partiellement en face d'une partie affleurante de la seconde couche de type P (P2) et partiellement en face d'une partie de la troisième région de type N (N3),
- une partie de la deuxième région de type N (N4) étant en face d'une part de ladite partie affleurante de la seconde couche de type P (P2) ;
- ce triac étant caractérisé en ce qu'une part de ladite partie affleurante de la seconde couche de type P (P2) est située au-dessous de la petite partie (P'1) affleurante de la première couche de type P (P1) qui est recouverte par l'électrode de gâchette (G).

2. Triac selon la revendication 1, caractérisé en ce que la partie affleurante de la seconde couche de type P (P2) qui est en face de l'électrode de gâchette (G) est constituée par une extension de la majeure partie affleurante de la seconde couche de type P (P2) et en ce que la partie de la troisième région de type N (N3) qui est en face de l'électrode de gâchette (G) n'est pas percée de trous de court-circuit alors que des trous de court-circuit (CC3) sont répartis dans le reste de la troisième région.

3. Triac selon la revendication 1, caractérisé en ce que la partie affleurante de la seconde couche de type P (P2) qui est en face de l'électrode de gâchette (G) est constituée par des trous de court-circuit (CC2) par lesquels la deuxième couche de type P (P2) remonte à la face inférieure à travers la troisième région de type N (N3), l'électrode de gâchette étant par ailleurs partiellement en face d'une partie de la troisième région non percée de trous de court-circuit.

4. Triac selon la revendication 3, caractérisé en ce que la partie d'électrode de gâchette (G) en face de la partie de la troisième région de type N (N3) non percèe de trous de court-circuit est la plus proche de la majeure partie affleurante de la première couche de type P (P1), tandis que la partie d'électrode de gâchette en face de trous de court-circuit (CC2) est la plus éloignée de la majeure partie affleurante de la première couche de type P (P1).

## Claims

1. Triac comprising a semiconductor structure having an upper face covered with a first main electrode (A1) and a gate electrode (G), and a lower face covered with a second main electrode (A2), the structure including:
- an N-type central layer (N2) extending through the middle of the whole structure,
- a first P-type layer (P1) covering the central layer (N2) on the upper face side,
- a second P-type layer (P2) covering the central layer (N2) on the lower face side,
- a first N-type region (N1) formed in the first P-type layer (P1), substantially in one half of the structure, and being flush with the upper face of said half, the first N-type region (N1) being moreover pierced with small holes (CC1), so called emitter shorts, through which the first P-type layer (P1) rises and is flush with the upper surface,
- a second N-type region (N4) formed in another part of the first P-type layer (P1) and being flush with the upper face in this other part, while the first P-type layer (P1) is flush with the rest of the upper face,
- a third N-type region (N3) formed in substantially the other half of the second P-type layer (P2) and flush with the lower face of said half, whereas the second P-type layer (P2) is flush with the rest of the lower face, the third N-type region (N3) being at least partially in front of the second N-type region (N4) and being moreover pierced with small holes so called emitter shorts (CC3) through which the second P-type layer (P2) comes flush with the lower face,
- the first main electrode (A1) covering substantially the whole of the first N-type region (N1) including the shorting holes of this first region, and covering a major flush part of the first P-type layer (P1) but not covering the first N-type region (N4) and the first P-type region (P1) in the immediate vicinity of the second N-type region (N4),
- the gate electrode (G) covering substantially the whole of the second N-type region (N1) as well as a small flush part (P'1) of the first P-type layer (P1), this small part being spaced apart from the major flush part of the first P-type layer (P1) and being connected to this major part by a narrow flush portion (P''1) of the first P-type layer (P1), this narrow portion surrounding the second N-type layer (N4) and not being covered by an electrode,
- the gate electrode being partially in line with a flush part of the second P-type layer (P2) and partially in line with a part of the third N-type region (N3),
- a part of the second N-type region (N4) being in line with a portion of said flush part of the second P-type layer (P2),
this triac being characterized in that a portion of said flush part of the second P-type layer (P2) extends below the small flush part (P'1) of the first P-type layer (P1) which is covered by the gate electrode (G).

2. The triac as claimed in claim 1, characterized in that the flush part of the second P-type layer (P2) which is in line with the gate electrode (G) is formed by a protrusion of the major flush part of the second P-type layer (P2) and in that the part of the third N-type region (N3) which is in line with the gate electrode (G) is not pierced with shorting holes, whereas shorting holes (CC3) are distributed through the rest of the third region.

3. The triac as claimed in claim 1, characterized in that the flush part of the second P-type layer (P2) which is in line with the gate electrode (G) is formed by shorting holes (CC2) through which the second P-type layer (P2) rises to the lower face through the third N-type region (N3), the gate electrode (G) being moreover partially in line with a part of the third region not pierced with shorting holes.

4. The triac as claimed in claim 3, wherein the gate electrode part (G) in line with the part of the third N-type region (N3) not pierced with shorting holes is the closest to the major flush part of the first P-type layer (P1), whereas the gate electrode part in line with shorting holes (CC2) is the furthest away from the major flush part of the first P-type layer (P1).

## Patentansprüche

1. Triac aus einer Halbleiterstruktur, auf deren Oberseite eine erste Hauptelektrode (A1) und eine Steuerelektrode (G) und auf deren Unterseite eine zweite Hauptelektrode (A2) vorgesehen sind, wobei die Struktur folgende Merkmale aufweist:
- eine zentrale N-Schicht (N2), die sich in der Mitte über die gesamte Struktur erstreckt,
- eine erste P-Schicht (P1), die die zentrale Schicht (N2) auf der Oberseite bedeckt,
- eine zweite P-Schicht (P2), die die zentrale Schicht (N2) auf der Unterseite bedeckt,
- einen ersten N-Bereich (N1), der in einer Hälfte der Struktur in der ersten P-Schicht (P1) ausgebildet ist und bündig bis zur Oberfläche dieser Hälfte reicht, wobei dieser erste N-Bereich (N1) außerdem von kleinen, Emitterkurzschlüsse (CC1) genannten Löchern durchdrungen ist, durch die die erste P-Schicht (P1) hindurchgreift und bündig bis zur Oberfläche reicht,
- einen zweiten N-Bereich (N4), der in einem zweiten Teilbereich der ersten P-Schicht (P1) gebildet ist und bündig bis zur Oberfläche in diesen zweiten Teilbereich reicht, während die erste P-Schicht (P1) auf dem Rest der Fläche bündig bis zur Oberfläche reicht,
- einen dritten N-Bereich (N3), der in der anderen Hälfte der Struktur in der zweiten P-Schicht (P2) ausgebildet ist und bündig bis zur Unterseite dieser Hälfte reicht, während die zweite P-Schicht (P2) auf dem Rest der Fläche bündig bis zur Unterseite reicht, wobei der dritte N-Bereich (N3) zumindest teilweise dem zweiten N-Bereich (N4) gegenüberliegt und außerdem mit Emitter-Kurzschlüsse (CC3) genannten Löchern durchsetzt ist, durch die die zweite P-Schicht (P2) bündig bis zur Unterseite hindurchgreift,
- wobei die erste Hauptelektrode (A1) annähernd den gesamten ersten N-Bereich (N1) einschließlich der Kurzschlußlöcher dieses ersten Bereiches und zudem den größeren Teil der ersten bündig abschließenden P-Schicht (P1) überdeckt, jedoch nicht den ersten N-Bereich (N1) und die erste P-Schicht (P1) in unmittelbarer Nachbarschaft des zweiten N-Bereichs (N4);
- wobei die Steuerelektrode (G) annähernd den gesamten zweiten N-Bereich (N4) ebenso wie einen kleinen Teilbereich (P'1) der bündig abschließenden ersten P-Schicht (P1) überdeckt, wobei dieser kleine Teilbereich von dem größeren bündig abschließenden Teilbereich der ersten P-Schicht (P1) entfernt und mit dem größeren Teilbereich über einen engen Abschnitt (P''1) verbunden ist, der mit der ersten P-Schicht (P1) bündig abschließt, wobei dieser enge Abschnitt den zweiten N-Bereich (N4) umgibt und nicht durch eine Elektrode bedeckt ist;
- wobei die Steuerelektrode teilweise einem bündig abschließenden Teilbereich der zweiten P-Schicht (P2) und teilweise einem Teilbereich des dritten N-Bereiches (N3) gegenüberliegt,
- wobei ein Teilbereich des zweiten N-Bereiches (N4) einem Teil des bündig abschließenden Teilbereiches der zweiten P-Schicht (P2) gegenüberliegt,
- dadurch gekennzeichnet, daß bei dem Triac ein Teil des bündig abschließenden Teilbereiches der zweiten P-Schicht (P2) unterhalb des bündig abschließenden kleinen Teiles (P'1) der ersten P-Schicht (P1) gelegen ist, der durch die Steuerelektrode (G1) bedeckt ist.

2. Triac nach Anspruch 1, dadurch gekennzeichnet, daß der bündig abschließende Teilbereich der zweiten P-Schicht (P2), der der Steuerelektrode (G1) gegenüberliegt, durch eine Ausdehnung des größeren bündig abschließenden Teilbereichs der zweiten P-Schicht (P2) gebildet ist, und daß der Teilbereich des dritten N-Bereiches (N3), der der Steuerelektrode gegenüberliegt, nicht von Kurzschlußlöchern durchdrungen ist, während Kurzschlußlöcher (CC3) im Rest des dritten Bereiches verteilt sind.

3. Triac nach Anspruch 1, dadurch gekennzeichnet, daß der bündig abschließende Teilbereich der zweiten P-Schicht (P2), der der Steuerelektrode (G) gegenüberliegt, mit Kurzschlußlöchern (CC2) versehen ist, durch die die zweite P-Schicht (P2) bis auf die Unterseite durch den dritten N-Bereich (N3) hindurchgreift, wobei die Steuerelektrode außerdem teilweise einem Teilbereich des dritten, nicht mit Kurzschlußlöchern verbundenen Bereiches gegenüberliegt.

4. Triac nach Anspruch 3, dadurch gekennzeichnet, daß der Teilbereich der Steuerelektrode (G) gegenüber dem Teilbereich des dritten N-Bereiches (N3), der nicht von Kurzschlußlöchern durchdrungen ist, dem größeren bündig abschließenden Teilbereich der ersten P-Schicht (P1) am nächsten gelegen ist, während der Teilbereich der Steuerelektrode gegenüber den Kurzschlußlöchern (CC2) der von dem größeren bündig abschließenden Teilbereich der ersten P-Schicht (P1) am weitesten entfernt gelegene ist.
